Europäisches Patentamt

European Patent Office

Office européen des brevets

(19)

Publication number: **0 297 678**

**A1**

# EUROPEAN PATENT APPLICATION

(12)

(21) Application number: 88201343.6

(22) Date of filing: 29.06.88

(51) Int. Cl.⁴: **C23C 24/08 , H01B 1/22 ,**
**H05K 3/10 , H05K 3/20**

(30) Priority: 30.06.87 US 68593
08.06.88 US 204044

(43) Date of publication of application:
04.01.89 Bulletin 89/01

(84) Designated Contracting States:
AT BE CH DE ES FR GB GR IT LI LU NL SE

(71) Applicant: AKZO N.V.
Velperweg 76
NL-6824 BM Arnhem(NL)

(72) Inventor: **Parr, William John E**
**1506 Applegate Drive**
**Naperville Illinois 60565(US)**
Inventor: **Moy, Paul Yuet Yee**
**520 Easy Street**
**Des Plaines Illinois 60016(US)**
Inventor: **Frank, Dieter**
**25 West 75th Street**
**Naperville Illinois 60540(US)**

(74) Representative: **Sieders, René et al**
**AKZO N.V. Patent Department (Dept. CO)**
**P.O. Box 9300**
**NL-6800 SB Arnhem(NL)**

(54) **Conductive metallization of substrates without developing agents.**

(57) A conductive metal layer is formed on a substrate having a softening point above about 200°C by depositing copper or nickel particles on the substrate, and heating and pressing the metal particles. Unlike similar methods, no developing agent is required to render the metal layer conductive. The coated substrates are useful for a variety of uses such as EMI shielding and printed circuit boards.

EP 0 297 678 A1

# CONDUCTIVE METALLIZATION OF SUBSTRATES WITHOUT DEVELOPING AGENTS

## Background of the Invention

This invention related to the formation of a conductive layer of metal on a substrate. In particular, this invention relates to such a process wherein the conductive layer is formed from discrete metal particles of copper or nickel. The invention also particularly relates to such processes wherein the metal layer is rendered conductive without the aid of a chemical agent.

It is frequently desired to form a layer of conductive metal on a (generally) non-conductive substrate. Such composites are useful for printed circuit boards, electromagnetic interference (EMI) shielding, and so forth.

Japanese publication JP110704(84) (Shin Gijutsu Kaihat) reports that a conductive layer may be formed on a substrate by spraying super fine (e.g.: 0.02 um) metal particles with the aid of a carrier gas (e.g.: nitrogen or argon) onto a substrate, followed by low temperature (e.g.: 80°C) sintering. One significant disadvantage of this process is the limited availability of such fine metal dust. Further, the use of metal dust in an air spray system requires extensive hygienic safeguards.

Japanese publication JP66133(73) (Fujimori Kogyo) and DE2,163,118 (Fujimori Kogyo (Sakai)) both describe a process where metal particles are mixed with a binder, applied to a substrate, dried, and treated with an agent which is an acid, a halogen, or a halogenide. Such processes are inconvenient and damaging to equipment in their requirement for a binder and a corrosive agent.

GB 2,085,340 teaches a paint containing copper particles and optionally a wetting agent (preferably triethanolamine), which is useful for producing conductive coatings.

US 4,434,084 (Dupont (Hicks)) and DE 2,411,988 (Dupont (Beske)) both describe processes wherein a mixture of copper and tin particles are coated on a substrate with the aid of chemical activators and heat sufficient to melt the tin. In the US patent the chemical activators are an organic acid flux and an organic amine in an inert organic medium. In the German publication the chemical activator is a flux which may contain triethanolamine as an adjuvant.

## Summary of the Invention

In one aspect of the invention is a method of forming a conductive metal layer on a high temperature softening point substrate in which the metal particles are deposited on the substrate and subjected simultaneously to pressure and heat.

In another aspect the invention is a coated substrate made by the above method.

The method of the invention is convenient to carry out, involves relatively non-corrosive materials, and produces well adhered, very conductive metal coatings on substrates.

## Detailed Description of the Invention

One element of the invention is the use of nickel or copper particles. In general, any nickel or copper which is in the form of a powder is suitable for use in the invention. While not critical, the use of a plate-shaped (lamellar) metal particle is preferred. However, excellent results have been obtained with spherical particles. Of more importance is the particle size of the nickel or copper. The principal difficulty with large particle sizes is that of obtaining a uniform distribution of particles on the substrate and ensuring adequate particle-to-particle contact in a relatively thin metal layer. Generally, the particle size will be below 30, preferably below 20, and more preferably below 10 $\mu$m.

The copper or nickel need not be particularly pure and oxides may be present. Further, mixtures of copper or nickel with other metals may be used. When mixtures are used, the mixture is desirably at least 40, more desirably at least 50, preferably at least 60, and most preferably at least 70 weight % copper and/or nickel.

The metal particles are deposited on a substrate. Suitable substrates include virtually any material which is capable of being in a relatively soft, deformable state so as to be able to provide adherence of the metal powder to its surface and is capable of being in a relatively hard, non-deformable state so as to be able to provide a relatively formable state so as to be able to provide a relatively undisturbed layer of metal after the metal has become adhered: provided that the substrate, during the curing of the metal, has a softening point above about 200°C (or no softening point at all, e.g.: thermoset resins). Thus, material such as glass and synthetic resins are suitable, with synthetic resins being preferred.

For purposes of the invention, suitable synthetic resins may be divided into two categories, thermoplastic resins and uncured resins. Thermoplastic resins are typically employed by applying the metal powder to the surface of the resin, applying pressure to the thusly metal-covered resin while heating the resin to a temperature above about 200°C, such that the metal layer becomes conductive and the resin is so softened that the metal particles can be embedded into the surface of the resin, and cooling to ambient temperature. "Uncured" resins are typically employed by providing them in a completely uncured or semi-cured state (sufficiently uncured that the metal particles can adhere to the surface), applying the metal particles to the surface of the resin, curing the resin to cause it to harden (such that it softening points is above about 200°C or such that it has no softening point), and thereafter applying pressure to the thusly metal-covered resin while heating the resin to a temperature above about 200°C, such that the metal layer becomes conductive.

Suitable thermoplastic resins include polyetherimides (PEI) (Ultem); and polyethersulfones (PES) (Victrex) polyetheretherketone (PEEK), polyetherketone (PEK), polyarylate, polysulfone, polyarylsulfone, liquid crystalinepolymers, and thermoplastic polyimide resins. It may be noted that a common feature of such resins is a high degree of aromatic linking units. The presence of such structure commonly produces polymers which have high glass transition temperatures and flow temperatures above 200°C. In general, it is desirable to have, in the repeating units of the polymer, at least 40%, desirably at least 50%, and more desirably at least 60% of the carbon atoms being aromatic carbon atoms.

Exemplary "uncured" resins include thermoset resins such as epoxy, unsaturated polyester, and silicone rubber. Other uncured (or semi-cured) resins such as UV cure, electron beam cure, and ionizing radiation cure resins may also be employed. The presence of the metal layer, however, means that curing by these means could only take place from the uncoated side of the resin.

The substrates are illustratively in the form of thin (eg: 0.5 to 1 mm) sheets but other forms (eg: cubes, spheres, etc.) would be suitable. The substrates may be selected from the usual commercial grades of available materials, and no special handling or treatment is required. Although the surface to be coated should be relatively free of dirt and grease, cleaning steps are not required unless the substrate has been subjected to an unusual amount of surface contamination.

It is specifically not a requirement of the invention that the metal particles be contacted with a developing agent. However, the use of a developing agent can, in some instances, improve the conductivity or adhesion of the metal layer. Further information concerning the selection use of developing agents, as well as other relevant information, is contained in Applicants' aforementioned application, Conductive Metallization of Substrates, which is incorporated herein by reference.

The metal particles are deposited on the substrate by any means which will achieve a layer of particles sufficiently uniform that a conductive surface can be achieved. A preferred method of deposition is to spray a dilute suspension (about 5-15 weight% metal) of the metal in a volatile organic solvent such as dichloromethane. For this purpose, ordinary spray equipment such as used for painting may be employed.

Another preferred method is to coat the metal particles onto a transfer plate (such as an aluminum plate, by spraying or other means, and then pressing that plate onto the surface of the substrate. The transfer plate is also preferably used as the molding plate (discussed further below). If the transfer plate has been milled or etched to form a raised pattern, then the metal particles will form the mirror image of that pattern on the substrate.

A mask can be used to form a pattern when metal is deposited by the direct spray method or the transfer plate method. Other methods of application such as roller coating, electrostatic coating, fluidized bed coating, and so forth may also be used.

In the case of substrates other than uncured resins, it is generally necessary to induce adhesion of the metal particles to the substrate. To achieve desirable levels of adhesion of the metal, the coated substrate is desirably subjected to heat and pressure.

One function of the heat and pressure is to cause the particles to physically become embedded in the substrate. The heat required is that which is sufficient to cause enough softening of the substrate that the metal particles can be forced into the surface of the substrate. Obviously, the temperature at which the substrate softens will vary considerably depending on the substrate chosen. Molding temperature for a number of specific substrates are presented in the Examples. The glass transition temperature (Tg) of a substrate is a useful guide for choosing a molding temperature, but molding temperatures are typically higher than the glass transition temperature of the substrate. If the molding temperature is too low, there will be insufficient flow of the substrate and lack of adequate adhesion. If the temperature is too high, the substrate will melt and perhaps degrade. Simple trial and error can easily determine the optimum molding temperature for any substrate.

Pressure is used in addition to heat to physically push the particles into the softened substrate. The precise amount of pressure is not critical, and merely needs to be sufficient to deform the metal particles to render them conductive. Typically molding pressures of about 5-100 MPa will be suitable.

The pressure may be provided by any conventional means. There is no minimum time for maintaining the pressure except that the pressure must be maintained for a sufficient length of time to allow the substrate to reach the developing (and optionally molding) temperature.

Whether or not heat is used to aid the adhesion of the metal to the substrate, heat is necessary to render the metal layer conductive. The temperature needed for rendering conductivity ("developing") can vary, but generally, a temperature of 200 to 400°C, preferably 220 to 350°C, and more preferably 240 to 280°C is required.

The exclusion of oxygen is believed to be important to the development of the metal to a conductive state, however, the use of a press to cause the metal to adhere to the substrate will inherently exclude oxygen and result in no special means for excluding oxygen being need.

The process of the invention is subject to numerous other variations. In particular, the substrate may be a composite of several layers, with only the top layer providing for adhesion of the metal. For instance, a sheet of cured thermoset resin may be coated with a thin film of uncured thermoset resin, the metal added, the resin cured, and then the substrate heated and pressed. In other variations a solution of a polymeric material may be cast onto a base substrate, the metal put onto the solution while it is still tacky, the solvent evaporated, and the substrate pressed and heated to render conductivity.

The metallized substrates of the invention are useful in a wide variety of applications including printed circuit boards, EMI shielding, capacitors, battery plates, electrical switches, and decorative panels.

The following examples are set forth further explain the invention.

Example 1a (Comparative)

This examples illustrates that for substrates not within the scope of the invention, good (high) conductivity, can be achieved only in the presence of a suitable developing agent.

Part A: A performed plaque of high-impact polystyrene (HIPS) about 3" x 4" x 0.03" thick (76 x 102 x 0.76 mm) was sprayed with a suspension of copper powder in dichloromethane and dried in an oven at 55°C (to evaporate the solvent completely). The copper applied weighed about 0.3 g and exhibited slight adhesion to the plastic as a result of solvent swelling of the surface during spray up. The coated preform could thus be manipulated without the coating falling off, but if the coating was rubbed the copper became detached.

At this stage surface resistance of the coating was greater than $10^7$ ohms/square. The coated preform was then compression molded between chromed steel plates at 215°C for 12 min under 5 tons/square inch (69 MPa) pressure. The molds were cooled in a second press at 20°C and the plastic removed. The copper powder had become compressed into the surface of the plastic (since the molding was done at above the temperature at which the polymer became fluid) to form a well adhered continuous copper layer. This layer was orange in color and had a surface resistance of greater than $10^6$ ohms/square.

Part B: a HIPS preform was sprayed with copper powder as in Part A, dried, and then sprayed with a 5% solution of N,N-bis(2-hydroxyethyl)-cocoamine in dichloromethane so as to afford a 3:1 weight ratio of Cu:amine after drying in an oven at 55°C to evaporate the solvent. The coated preform was compression molded as in Example 1a. After development the well-adhered copper coating was pink in color and possessed a surface resistance of 0.01 ohms/square. The use of the developing agent thus improved the conductivity by a factor of $10^8$.

Example 2

A. Preforms were prepared from polyethersulfone (Victrex® 4100P, ICI) by molding at 240°C. Attempts to incorporate N,N bis(2-hydroxyethyl)-tallow amine into the PES by extrusion resulted in non-homogenous, somewhat brittle, samples.

B. A series of PES preforms 4" x 4" x 0.03" were sprayed with a suspension of copper powder in dichloromethane to give a weight gain of about 0.25 g of copper after solvent evaporation. The preforms were compression molded at various temperatures between 150°C and 250°C for 10 min at 5 tpsi (69 MPa) pressure. After cooling, the copper layers were examined for conductivity by the four-probe method, and for adhesion by means of tape attached to the metal surface. Following this the samples were cut in half and one half sprayed with a solution of N,N-bis(2-hydroxyethyl)tallowamine in dichloromethane to give Cu:amine ratios of around 2:1 to 4:1 and then molded a further 10 min. After cooling the conductivity and adhesion were reassessed. Below 220°C adhesion of the copper layer was generally poor due to non-flow of the PES, and the copper could easily be scratched away. At 200-220°C there was some evidence which indicated that treatment with the amine improved the adhesion of the copper. Above 220°C adhesion of the copper coatings was much improved, particularly in the presence of developer, due to good flow of the PES. Use of the amine in samples molded at below 220°C led to copper layers exhibiting enhanced conductivity (below 0.1 ohms/square) but of insufficient adhesion. Of particular interest however, was the observation that at temperatures above 200°C, copper powder sprayed onto PES polymer produced copper layers of high conductivity, in the absence of a developing agent.

C. PES pellets were subjected to solvent extraction in a Soxhlet apparatus for seven days using a mixture of xylene and chloroform (90:10), and then pressed into preforms. These were sprayed with copper power, and in some cases also with N,N-bis(2-hydroxyethyl)tallowamine and compression molded at 220°C. No difference in conductivity of the copper layer with or without the amine was observed (0.01 ohm/square) but use of developer enhanced the adhesion of the copper to the PES. These results indicate that the reason for the ability of PES to afford highly conductive layers of copper, when sprayed with copper powder and compression molded, is probably not due to the presence of polymerization catalyst residues or of phosphorus containing antioxidants.

D. Preforms were prepared from polyetherimide (Ultem® 1000, General Electric) by molding at 290°C. It was not possible to incorporate developers such as N,N-bis (2-hydroxyethyl)tallowamine into PEI without causing brittleness. PEI preforms were sprayed with a suspension of copper powder and compression molded 10 min under 5 tpsi (69 MPa) pressure at various temperatures. After assessing conductivity of the layer one half of the sample was sprayed with a solution of N,N-bis(2-hydroxyethyl)tallowamine and remolded 10 min and the copper layer then reassessed for conductivity. At temperatures below 200°C the use of the amine caused a reduction of the resistance from $10^6$ ohms/square to less than 1 ohm/square but metal adhesion was poor both with and without the amine. With PEI significant resin flow does not occur under pressure below 230-240°C. Thus in order to achieve well-adhered copper coatings on PEI compression molding must be performed at 230°C or above. In the absence of developer the coppers layers formed on PEI tend to be orange in color and lack luster. Use of the amine improves both the color and lustre of the copper layer and can improve conductivity (see Example 4.E).

E. PEI pellets were solvent extracted as in (C), molded into preforms, and reassessed (with copper powder) in the absence and presence of N,N-bis(2-hydroxyethyl)tallowamine. It was observed that solvent extraction did not prevent PEI from affording conductive copper layers in the absence of a developer when sprayed with copper powder and molded at 220°C. It may be noted that use of the amine at 220°C and above improved the adhesion of the copper layer.

F. PEI preforms were sprayed with a suspension of nickel powder (Alcan® 756) in tetrahydrofuran and dried. After being compression molded for 10 min at 230°C under 5 tpsi (69 MPa) pressure, and cooled the preform was found to bear a grey layer of nickel which exhibited high conductivity in many areas. The same experiment was repeated except that N,N-bis(2-hydroxyethyl)tallowamine was sprayed onto the nickel powder coated preform prior to molding After cooling the preform was found to possess a shiny, well-adhered, nickel layer of high conductivity. When similar experiments were carried out at 180°C adhesion of the nickel to PEI was inadequate. These results indicate that the attainment of highly conductive nickel coatings upon PEI do not necessarily require the use of a developer.

Example 3

The following examples illustrate the principle of transfer molding as applied to the process of the invention.

A. A 1/4" (6.3 mm) thick aluminum block was milled to produce a positive image of the circuit pattern required for a simple circuit based on the NE555 timer integrated circuit upon the raised portions. This pattern piece was sprayed with a suspension of copper powder in dichloromethane and then compression molded in contact with a 0.03" (0.76 mm) thick piece of polyetherimide for 10 min at 220°C under 5 tpsi (69 MPa). By filling the hollow areas of the aluminum pattern piece with a Viton rubber filler of the appropriate thickness sagging of the PEI remained relatively flat after the transfer molding

Upon cooling it was found that the copper powder had transferred from the aluminum to the surface of the PEI to form an orange circuit pattern. Corner to corner resistance over 5" (127 mm) or so of 3/16" (4.8 mm) wide track was around 100-200 ohms using 2 ohmmeter probes. Better adhesion of the metal (due to improved PEI fluidity) was obtained by molding at 240°C but this produced some "flashing" (ie: oozing of the resin out of the mold).

B. An experiment was preformed as in (A) except that the mold temperature was 220°C and the copper powder coated aluminum pattern was sprayed with a solution of N,N-bis(2-hydroxyethyl)-tallowamine in dichloromethane before the molding cycle. Again, after cooling, clean transfer of the copper to the PEI surface had occured, but this time the corner to corner resistance over the same distance was reduced to 1 ohm (or better) using 2 ohmmeter probes, and the copper was a lustrous pink in color.

C. An experiment was performed as in (A) to give an orange circuit pattern upon the PEI with a corner to corner resistance of 100-200 ohms. The PEI/Cu patterned preform was then sprayed with a solution of N,N-bis(2-hydroxyethyl)-tallowamine in dichloromethane and then re-compression molded between chrome-plated steel sheets. Upon cooling the copper layer had turned pink and the corner to corner resistance lowered to 1 ohm (or better).

D. The PEI circuit board fabricated in (B) was drilled and a wire attached successfully by conventional soldering.

E. A 0.03" (0.76 mm) thick piece of polyetherimide which bore a circuit pattern formed by transfer molding of copper from an aluminum pattern in the absence of developer at 200°C and possessing a resistance of 6 ohms over a 3" (76 mm) length of 1/8" (3.2 mm) wide copper track using 2-probes was placed in an evacuated tube containing 6 drops of N,N-bis(2-hydroxyethyl) cocoamine and the tube placed in an over for 30 min at 200°C. After cooling the resistance of the same track measured over the same distance had been reduced to 0.1 ohm/square and the color of the copper changed from orange to pink.

## Claims

1. A method of forming a conductive metal layer on a substrate, comprising:

a. a depositing step of depositing a layer of copper or nickel metal particles on a temporarily deformable substrate having a softening point of about 200°C or higher; and

b. a heating and pressing step of subjecting the metal particles to pressure and a temperature above about 200°C for a duration sufficient to improve the conductivity of the metal layer.

2. The method of claim 1 wherein said depositing step comprises spraying the metal particles onto the substrate with the aid of a fluid suspension agent.

3. The method of claim 1 wherein the copper or nickel contains less than about 40 weight % of non-conductive layer forming metals.

4. The method of claim 1 wherein the metal particles have a number average particle size of less than about 30 μm.

5. The method of claim 1 wherein the metal particles are in the form of flakes.

6. The method of claim 1 wherein said heating and pressing step takes place at 200-400°C.

7. The method of claim 1 wherein the pressure is 5-100 MPa.

8. The method of one or more of the claims 1-7 wherein the resin is a polyether sulfone, a polyetherimide, a polyetheretherketone (PEEK), a polyetherketone (PEK), polyarylate, a polysulfone, a polyarylsulfone, a liquid crystalline polymer, or a thermoplastic polyimide resin.

9. The method of one or more of the claims 1-7 wherein the substrate is an incompletely cured thermoset resin which is cured after said depositing step but before said heating and pressing step.

10. The method of one or more of the claims 1-9 wherein said depositing step comprises applying the metal particles to a transfer surface and pressing the transfer surface against the substrate.

11. A coated substrate produced by the method of one or more of the claims 1-10.

12. A method of shielding a space from a source of EMI comprising placing the coated substrate produced by the method of one or more of the claims 1-10 between the source of EMI and the space to be shielded.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | EP-A-0 203 299 (ALLIED CORP.) <br> * Whole document * <br> --- | 1,2,4-8 ,11 | C 23 C 24/08 <br> H 01 B 1/22 <br> H 05 K 3/10 <br> H 05 K 3/20 |
| A | US-A-4 499 152 (GREEN et al.) <br> * Claim 11 * <br> --- | 10 | |
| A | CH-A- 450 099 (INTERNATIONAL NICKEL LTD) <br> * Claims * <br> --- | 1,2 | |
| A | CH-A- 497 542 (INTERNATIONAL NICKEL LTD) <br> * Claims * <br> --- | 1,2 | |
| D,A | CHEMICAL ABSTRACTS, vol. 101, no. 22, November 1984, page 280, no. 196682v, Columbus, Ohio, US; & JP-A-59 110 704 (RESEARCH DEVELOPMENT CORP. OF JAPAN) 26-06-1984 <br> ----- | 1,12 | |

TECHNICAL FIELDS SEARCHED (Int. Cl.4)

C 23 C
H 01 B
H 05 K

The present search report has been drawn up for all claims

| Place of search | Date of completion of the search | Examiner |
|---|---|---|
| THE HAGUE | 08-09-1988 | ELSEN D.B.A. |

EPO FORM 1503 03.82 (P0401)